# EUROPEAN PATENT SPECIFICATION

(11) **EP 1 298 050 B1**
(45) Date of publication and mention of the grant of the patent: **15.09.2004**
(21) Application number: 02014980.3
(22) Date of filing: 09.07.2002
(51) Int. Cl.: B62M 23/02

(54) **Indicator of a motor-assisted bicycle**
Anzeige für ein Fahrrad mit Hilfsmotor
Indicateur de charge pour bicyclette à assistance motorisée

(30) Priority: 28.09.2001 JP 2001303697
(43) Date of publication of application: 02.04.2003
(73) Proprietor: Honda Giken Kogyo Kabushiki Kaisha, Minato-ku, Tokyo (JP)
(72) Inventor: Akiba, Ryuji, 1-4-1 Chuo, Wako-shi, Saitama-ken (JP); Cho, Toshiyuki, 1-4-1 Chuo, Wako-shi, Saitama-ken (JP)
(74) Representative: Liska, Horst, Dr.-Ing.

(56) References cited:
- DE-A- 3 003 026
- DE-A- 19 732 468
- GB-A- 2 116 728
- US-A- 5 798 702
- US-A- 5 963 140

## Description

The present invention relates to an indicator of a motor-assisted bicycle, and particularly to an indicator of a motor-assisted bicycle that can display conditions of assist, regenerative charging and the like by an assist motor.

An indicator according to the preamble of claim 1 is known from DE 197 32 468 A.

A motor-assisted bicycle is known which includes a human power driving system for transmitting pedaling power applied to a pedal to a rear wheel and a motor driving system capable of adding assist power to the human power driving system according to the pedaling power. With the motor-assisted bicycle, it is desirable to alleviate battery wear and thereby extend a distance traveled on a single charge. Japanese Patent Laid-Open No. 2000-72080, for example, discloses an assist power controlling method of a motor-assisted bicycle for reducing battery wear by stopping supply of current to a motor or lowering the value of the current in conditions where assist power is not required, such as during traveling on a flat road.

The motor-assisted bicycle is also known to perform regenerative charging during application of the brakes on a downward slope and the like to use energy efficiently.

However, the conventional motor-assisted bicycle performs regenerative charging under predetermined conditions, and therefore no special consideration is given to regenerative charging adjusted to an intention or needs of the user and an indicator for indicating conditions of the regenerative charging.

The present invention has been made in view of the prior art described above, and it is accordingly an object of the present invention to provide an indicator that displays conditions of assist, regenerative charging and the like and allows an operator to visually check the conditions in a motor-assisted bicycle capable of regenerative charging adjusted to an intention or needs of the user.

This object is achieved by an indicator for a motor-assisted bicycle according to claim 1.

The present invention has a first feature in that an indicator for displaying conditions of an assist motor of a battery-mounted motor-assisted bicycle that adds assist power to a human power driving system according to pedaling power applied to a pedal includes a first display unit for displaying an amount of regenerative charging of the battery. According to this feature, the operator can be aware of the amount of exercise of the operator and thus give strong recognition as a fitness tool to the bicycle. In addition, the operator is aware that the amount of exercise of the operator contributes to regenerative charging of the battery, and thus the operator can be motivated to exercise.

Moreover, the present invention has a second feature in that the indicator further includes a second display unit for displaying a control mode condition of the assist motor. According to this feature, the user can grasp control conditions of the assist motor, and thus can travel while recognizing excellent functions of the motor-assisted bicycle.

Furthermore, the present invention has a third feature in that the indicator further includes: a push button; and a third display unit for displaying a battery charge level when the push button is operated. According to this feature, it is possible to grasp not only a condition of the regenerative charging and the control mode of the assist motor but also the charge level of the battery with the same indicator, and to thus use the indicator for multiple purposes. It is also possible for the user to check the charge level of the battery while in a riding position.

A preferred embodiment of the present invention will hereinafter be described with reference to the drawings, in which:
FIG. 1 is a block diagram showing a circuit around an indicator according to the present invention.
FIG. 2 is a side view of a motor-assisted bicycle.
FIG. 3 is a sectional view of main parts of an electric assist unit.
FIG. 4 is a sectional view taken along an arrow line A-A in FIG. 3.
FIG. 5 is a plan view of an example of a power supply switch unit.
FIG. 6 is a diagram of assistance in explaining conditions for assist cut, showing a pedaling power history.
FIG. 7 is a diagram of assistance in explaining conditions for starting assist, showing a pedaling power history.
FIG. 8 is a diagram of assistance in explaining conditions for starting assist at a plurality of pedaling power levels, the diagram showing a pedaling power history.
FIG. 9 is a flowchart illustrating main parts of processing in an eco mode including the assist and the assist cut.
FIG. 10 is a flowchart illustrating main parts of processing in a super eco mode including the assist and regenerative charging.
FIG. 11 is a block diagram of functions of main parts of a regeneration control apparatus according to an embodiment of the present invention.
FIG. 12 is a diagram of assistance in explaining a rough summary of control of an assist motor according to traveling conditions in each of an STD, an ECO, and an S-ECO mode.
FIG. 13 is a plan view of an embodiment of the indicator according to the present invention.
FIG. 14 is a flowchart mainly illustrating operation of an indicator driving unit.

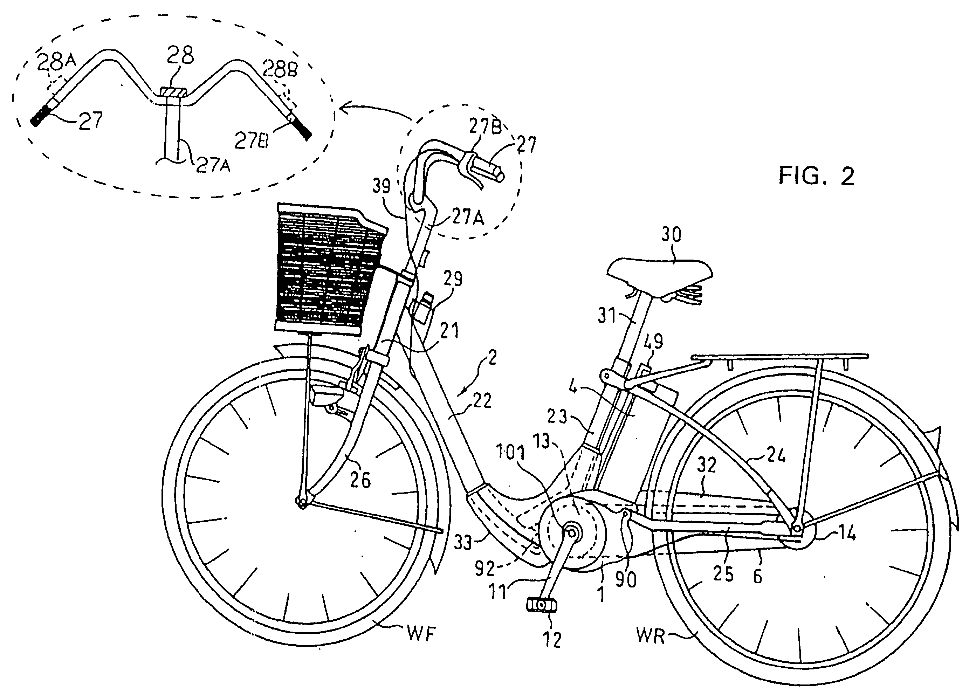

FIG. 2 is a side view of a motor-assisted bicycle according to the embodiment of the present invention.

A vehicle frame 2 of the motor-assisted bicycle includes: a head pipe 21 situated at the front of the frame; a down pipe 22 extending down rearward from the head pipe 21; and a seat post 23 rising upward from about an end portion of the down pipe 22. A portion where the down pipe 22 and the seat post 23 are joined to each other and the periphery of that portion are covered by a resin cover 33, which is divided into two parts, that is, an upper and a lower part for attachment and detachment. A steering handlebar 27 is rotatably inserted via a handlebar post 27A into an upper portion of the head pipe 21. A front fork 26, connected to the handlebar post 27A, is supported at a lower portion of the head pipe 21. A front wheel WF is rotatably journaled at a lower end of the front fork 26.

As shown in an enlarged front view enclosed by a broken line, an indicator 28 for displaying conditions of an assist motor (details will be described later), that is, an indicator 28 for displaying an assist condition, a regenerative charge condition and the like of the bicycle is attached to a central portion of the steering handlebar 27. A position for attaching the indicator 28 is not limited to the central portion of the steering handlebar 27; the position for attaching the indicator 28 may be one of a right and a left position 28A and 28B of the steering handlebar 27, or another position.

In a lower portion of the vehicle frame 2, an electric assist unit 1 serving as a driving unit including an electric motor (not shown) for pedaling power assist is bolted and hung at three positions, that is, a connecting portion 92 at a lower end of the down pipe 22, a connecting portion 91 provided at a front portion of a battery bracket 49 welded to the seat post 23, and a connecting portion 90 at a rear portion of the bracket 49. A chain stay 25 is bolted in conjunction with the electric assist unit 1 at the connecting portion 90.

A power supply switch unit (or mode switch) 29 of the electric assist unit 1 is disposed adjacent to the head pipe 21 on the down pipe 22. The power supply switch unit 29 allows selection of an eco mode (details will be described later) for reducing power consumption and a super eco mode (details will be described later) for reducing power consumption and increasing the frequency of regenerative charge. While the power supply switch unit 29 can be turned on by a key, the power supply switch unit 29 may be turned on by using an infrared signal and a remote control switch, for example. In that case, the power supply switch unit 29 is provided with a receiver for receiving the infrared signal sent from the remote control switch.

The electric assist unit 1 has a driving sprocket 13. Rotation of a crankshaft 101 is transmitted from the driving sprocket 13 through a chain 6 to a rear sprocket 14. The handlebar 27 is provided with a brake lever 27B. An operation of the brake lever 27B is transmitted through a brake wire 39 to a brake unit (not shown) of a rear wheel WR. In addition, a brake switch (not shown) that is turned on when the brake lever 27B is operated is provided, and the operation of the brake lever 27B is detected by the brake switch.

The crankshaft 101 is rotatably supported in the electric assist unit 1, and pedals 12 are journaled at both a right and a left end of the crankshaft 101 via a crank 11. The rear wheel WR serving as a driving wheel is journaled between ends of the pair of right and left chain stays 25 extending from the electric assist unit 1 to the rear side. A pair of right and left seat stays 24 is provided between an upper portion of the seat post 23 and the ends of both the chain stays 25. A seat pipe 31 provided with a seat 30 at an upper end thereof for adjusting height of the seat 30 is inserted in the seat post 23 so as to be slidable in the seat post 23.

A battery 4 is mounted in the rear of the seat post 23 and under the seat 30. The battery 4 is housed in a housing case and then attached to the battery bracket 49. The battery 4 includes a plurality of battery cells, and is mounted along the seat post 23 so that a longitudinal direction of the battery 4 is a substantially vertical direction.

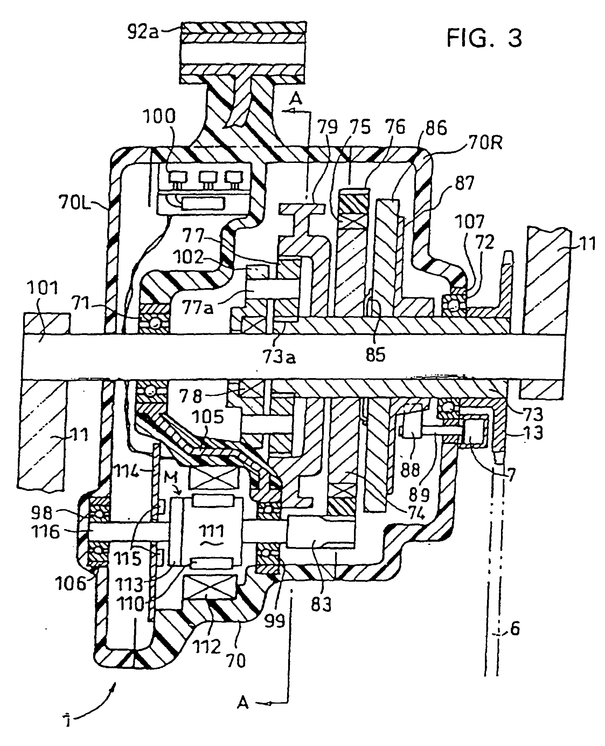

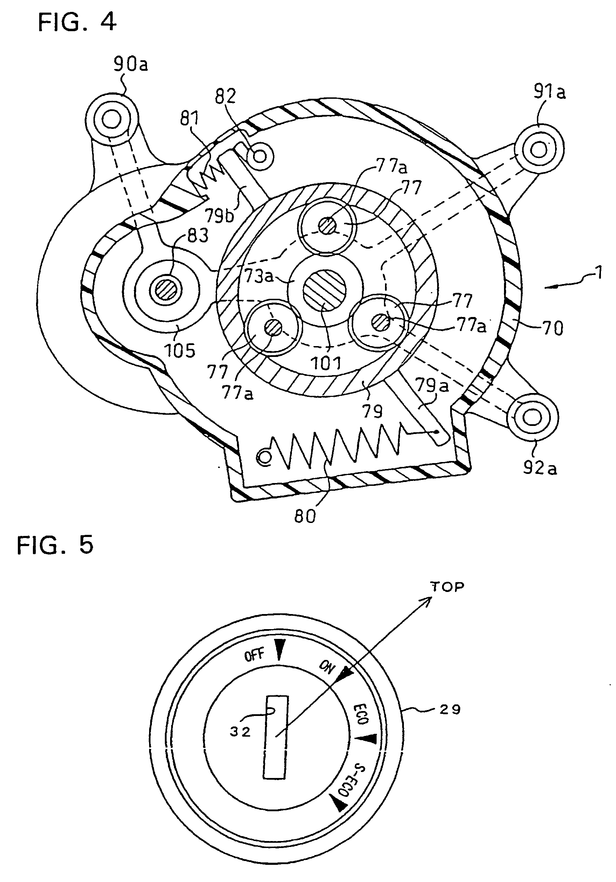

FIG. 3 is a sectional view of the electric assist unit 1, and FIG. 4 is a view taken along an arrow line A-A in FIG. 3. A case of the electric assist unit 1 is formed by a main body 70, and a left cover 70L and a right cover 70R that are attached to both sides of the main body 70. The case 70, the left cover 70L, and the right cover 70R are produced from a molded resin product for lighter weight. Hangers 90a, 91a, and 92a conforming to the connecting portions 90, 91, and 92, respectively, of the down pipe 22 and the battery bracket 49 are formed around the periphery of the case main body 70. A bearing 71 is provided in the main body 70, and a bearing 72 is provided in the right cover 70R. The crankshaft 101 is in contact with the inside of an inner ring of the bearing 71, and a sleeve 73 provided to the crankshaft 101 on the same axis as that of the crankshaft 101 so as to be slidable in a direction of an outer circumference of the crankshaft 101 is in contact with the inside of an inner ring of the bearing 72. Thus, the crankshaft 101 is supported by the bearing 71 and the bearing 72.

A boss 74 is fixed to the sleeve 73, and an assist gear 76 is provided on the periphery of the boss 74 with a one-way clutch 75 formed by a ratchet mechanism, for example, intermediate between the boss 74 and the assist gear 76. It is desirable that the assist gear 76 be made of resin from a viewpoint of weight reduction, and be a helical gear from a viewpoint of quietness and the like.

A gear 73a is formed at an end portion of the sleeve 73. Three planet gears 77 are arranged on the periphery of the gear 73a with the gear 73a serving as a sun gear. The planet gears 77 are supported by shafts 77a disposed in standing relation to a supporting plate 102, and the supporting plate 102 is supported by the crankshaft 101 with a one-way clutch 78 intermediate between the supporting plate 102 and the crankshaft 101. The planet gears 77 are engaged with an inner gear formed on the inner periphery of a pedaling power detecting ring 79. The driving sprocket 13 connected to the rear sprocket 14 via the chain 6 is fixed to an end portion (side having no gear formed) of the sleeve 73.

The pedaling power detecting ring 79 has arms 79a and 79b projecting from the periphery of the pedaling power detecting ring 79. The arms 79a and 79b are biased in a direction (clockwise direction in the figure) opposite to a rotating direction of the crankshaft 101 at the time of travel by an extension spring 80 provided between the arm 79a and the main body 70 and a compression spring 81 provided between the arm 79b and the main body 70. The compression spring 81 is provided to prevent wobbling of the ring 79. The arm 79b is provided with a potentiometer 82 for detecting displacement in a rotating direction of the ring 79.

A clutch plate 86 for regeneration is disposed adjacent to the assist gear 76 with a spring washer 85 intermediate between the clutch plate 86 and the assist gear 76. A pressure plate 87 for pressing the clutch plate 86 to the assist gear 76 side against action of the spring washer is disposed adjacent to the clutch plate 86. Both the clutch plate 86 and the pressure plate 87 are provided so as to be slidable in a direction of the axis of the sleeve 73.

The pressure plate 87 is biased to the clutch plate 86 side by a cam 88 in contact with an inclined surface formed on a hub portion of the pressure plate 87. The cam 88 is rotatably supported from the right cover 70R by a shaft 89. An actuator 7 is fixed to an end portion of the shaft 89, that is, a portion projecting from the right cover 70R to the exterior thereof. As is clear from later description, the actuator 7 is controlled by a regeneration control signal supplied from a controller 100. When the actuator 7 rotates by a controlled amount, the cam 88 correspondingly rotates on the shaft 89. Incidentally, a solenoid may be used instead of the actuator 7.

The assist gear 76 is engaged with a pinion 83 fixed to a shaft of the assist motor M. The assist motor M is a three-phase brushless motor. The assist motor M includes: a rotor 111 having a magnetic pole 110 of a neodymium (Nd-Fe-B) magnet; a stator coil 112 provided around the periphery of the rotor; a rubber magnet ring (ring formed by alternately arranging north poles and south poles) 113 for a magnetic pole sensor, provided on a side of the rotor 111; a Hall IC 115 disposed opposite to the rubber magnet ring 113 and mounted on a substrate 114; and a shaft 116 of the rotor 111. The shaft 116 is supported by a bearing 98 provided in the left cover 70L and a bearing 99 provided in the case main body 70.

The controller 100 including a FET and a capacitor for a driver for controlling the assist motor M and the actuator 7 is provided on the front frame side of the case main body 70. Power is supplied through the FET to the stator coil 112 and the actuator 7. The controller 100 operates the assist motor M and the actuator 7 according to the pedaling power detected by the potentiometer 82 serving as a pedaling power detector to thereby cause assist power and regeneration.

While it is desirable to form the case main body 70, the covers 70L, and 70R from a molded resin product from a viewpoint of weight reduction, strength of the periphery of the bearings and the like needs to be enhanced. In the electric assist unit 1 according to the present embodiment, reinforcing members 105, 106, and 107 of metal such as iron, aluminum, aluminum alloy, or copper alloy are disposed around the periphery of the bearings. Since reinforcing members to be disposed in the case main body 70, in particular, reinforce parts where heavy loads are expected, such as the bearing 71 for the crankshaft 101, the bearing 99 for the motor shaft 116, and the hangers 90a, 91a, and 92a serving as members for attachment to the vehicle frame, the reinforcing members of the parts are joined to each other to form an integral reinforcing plate 105. With this reinforcing plate 105, the reinforcing members disposed around the bearings and the hangers can further enhance the reinforcing effect in conjunction with each other.

The reinforcing plate 105 is not limited to the one formed by joining all the reinforcing members around the bearing 71, the bearing 99, and the hangers 90a, 91a, and 92a; the reinforcing plate 105 may be formed by joining adjacent ones of the reinforcing members, such for example as the reinforcing member around the hanger 90a and the reinforcing member around the bearing 99, or the reinforcing member around the bearing 71 and the reinforcing member around the bearing 99 or one of the hangers 90a, 91a, and 92a. Incidentally, it is desirable to form the reinforcing members 105, 106, and 107 integrally with the case 70 and the covers 70L and 70R at the time of resin molding.

In the thus formed electric assist unit 1, when pedaling power is applied to the crankshaft 101 via the crank 11, the crankshaft 101 is rotated. The rotation of the crankshaft 101 is transmitted to the supporting plate 102 via the one-way clutch 78, thereby the shafts 77a of the planet gears 77 are revolved around the sun gear 73a, and the sun gear 73a is rotated via the planet gears 77. The rotation of the sun gear 73a rotates the driving sprocket 13 fixed to the sleeve 73.

When a load is applied to the rear wheel WR, the pedaling power detecting ring 79 is rotated according to the magnitude of the load, and the amount of rotation is detected by the potentiometer 82. When an output of the potentiometer 82, that is, an output corresponding to the load is higher than a predetermined value, the assist motor M is energized according to the magnitude of the load to generate assist power. The assist power is combined with driving torque generated in the crankshaft 101 by human power, and then transmitted to the driving sprocket 13.

When the brakes are applied to decelerate the vehicle during traveling, the brake switch is turned on, and then the actuator 7 is driven to rotate by a predetermined amount. Then, the cam 88 is rotated on the shaft 89, whereby the pressure plate 87 presses the clutch plate 86. Subsequently, the clutch plate 86 is biased to the assist gear 76 side, thereby the boss 74 and the assist gear 76 are coupled to each other, and rotation of the boss 74 is transmitted to the assist gear 76. Thus, rotation of the driving sprocket 13 during braking is transmitted through the sleeve 73, the boss 74, and the assist gear 76 to the pinion 83. The pinion 83 is rotated to thereby generate an electromotive force in the stator coil 112, and thus regeneration is performed. A current resulting from the generation is supplied to the battery 4 via the controller 100 to charge the battery 4.

The present embodiment allows selection by operation of the operator of a mode in which assist is cut when predetermined control criteria are satisfied, as at the time of traveling a flat road, assist is resumed when predetermined other control criteria are satisfied, and regenerative charging is performed while the brake switch is on (hereinafter referred to as an "eco mode"), and a mode in which regenerative charging is performed when predetermined control criteria are satisfied during traveling on a flat road and during traveling on a downward slope, and assist is resumed when predetermined other control criteria are satisfied (hereinafter referred to as a "super eco mode"). FIG. 5 is a plan view of an example of the power supply switch unit 29.

In the figure, the modes can be selected by inserting a key not shown in the figure into a keyhole 32 and rotating the key. When the key is in an "OFF" position, power to the electric assist unit 1 is off, and therefore no power is supplied from the battery 4 to the electric assist unit 1. When the key is rotated to an "ON" position, power can be supplied to the electric assist unit 1, and where pedaling power exceeds a predetermined value, the assist motor M is controlled to provide assist power according to a ratio (assist ratio) between the assist power and the pedaling power which ratio is read from a preset map. When the key is set to an "ECO" position, the eco mode is selected and it is possible to effect control to start and cut assist according to predetermined control criteria, as will be described in detail later. When the key is set to an "S-ECO" position, the super eco mode is selected and it is possible to effect control to start assist and perform regenerative charging according to predetermined control criteria, as will be described in detail later. Incidentally, it is desirable to attach the power supply switch unit 29 to the vehicle frame such that the "ON" position is directed in a traveling direction of the vehicle.

Control for assist, assist cut, and regenerative charge in the eco mode and control for assist and regenerative charge in the super eco mode will next be described.

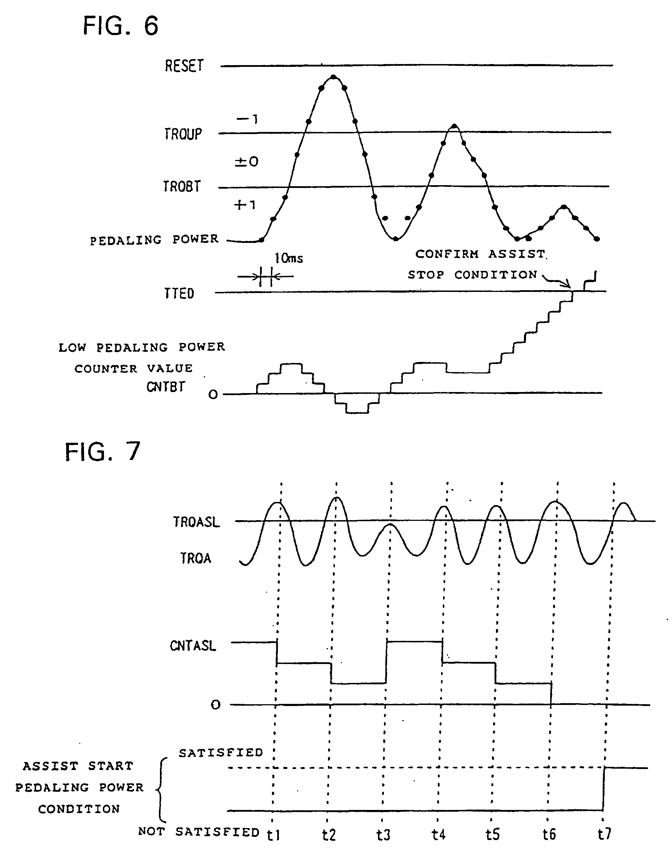

In the eco mode, assist is cut when a pedaling power history is detected and it is determined that the pedaling power remains at a level lower than a predetermined value and thus requiring no assist (hereinafter referred to as an "assist cut level"). FIG. 6 is a diagram of assistance in explaining conditions for assist cut, showing a pedaling power history and also showing a counter value CNTBT of a counter updated on the basis of the magnitude of the pedaling power. Incidentally, the pedaling power is varied periodically in such a manner as to correspond to a rotation cycle of the crank. In the figure, a pedaling power upper limit value TRQUP and a pedaling power lower limit value TRQBT are set. The pedaling power upper limit value TRQUP is set in a range of 15 to 20 kgf, for example, and the pedaling power lower limit value TRQBT is set in a range of 13 to 15 kgf, for example. The pedaling power is detected by interrupt processing at intervals of 10 milliseconds, for example.

When the pedaling power TRQA is the pedaling power lower limit value TRQBT or lower, the counter value CNTBT of the low level counter is incremented (+1), and when the pedaling power TRQA is the pedaling power upper limit value TRQUP or higher, the counter value CNTBT of the low level counter is decremented (-1). When the pedaling power TRQA is higher than the pedaling power lower limit value TRQBT and lower than the pedaling power upper limit value TRQUP, the counter value CNTBT is not changed. When the counter value CNTBT exceeds a reference value (counter reference value) TTED, it is determined that the pedaling power TRQA is at the assist cut level, and thereby assist is cut.

The counter value CNTBT can be reset when the pedaling power TRQA exceeds a reset level RESET set at a point higher than the pedaling power upper limit value TRQUP, or when conditions for starting assist, which will be described later, are satisfied. Also, regenerative charging is performed on preset conditions while the brake switch is on.

The regenerative charging in the super eco mode is performed on the same conditions as those of assist cut in the eco mode. Specifically, when the counter value CNTBT exceeds the reference value (counter reference value) TTED, it is determined that the pedaling power TRQA is at a regenerative charging level, and thereby regenerative charging is performed. In order to facilitate understanding of description in the following, a counter value KSR for conditions for starting regenerative charging is defined; however, the counter value KSR and the counter value CNTBT can be considered to be the same value.

Control for starting assist in the eco mode and the super eco mode will next be described. When a pedaling power history is detected and it is determined that the pedaling power is at a level requiring assist power (hereinafter referred to as an "assist level"), assist based on an assist ratio corresponding to the predetermined level is provided. FIG. 7 is a diagram of assistance in explaining conditions for starting assist, showing a pedaling power history and also showing a counter value CNTASL updated each time the pedaling power exceeds a reference value. In the figure, a reference value TRQASL of pedaling power level, which is a factor in determining a start of assist, is set, and the number of times that a peak value of the varying pedaling power TRQA exceeds the reference value TRQASL is set as the counter value CNTASL of an assist start counter. In this case, the counter value CNTASL is decremented (-1) each time a peak value of the pedaling power TRQA exceeds the reference value TRQASL. When the counter value CNTASL becomes "0" and the pedaling power TRQA exceeds the reference value TRQASL, it is determined that the pedaling power is at an assist requiring level, and thus conditions for starting assist are satisfied.

Specifically, FIG. 7 shows an example where an initial value of the counter value CNTASL is "3." In the figure, at times t1 and t2, the peak value of the pedaling power TRQA exceeds the reference value TRQASL and therefore the counter value CNTASL is decremented twice. The peak value in a next variation cycle does not exceed the reference value TRQASL, and therefore the counter value CNTASL is reset to the initial value at a time t3. Thereafter, the counter value CNTASL is decremented at times t4, t5, and t6 to "0." When the pedaling power TRQA exceeds the reference value TRQASL at a time t7, the conditions for starting assist are satisfied, whereby assist is started.

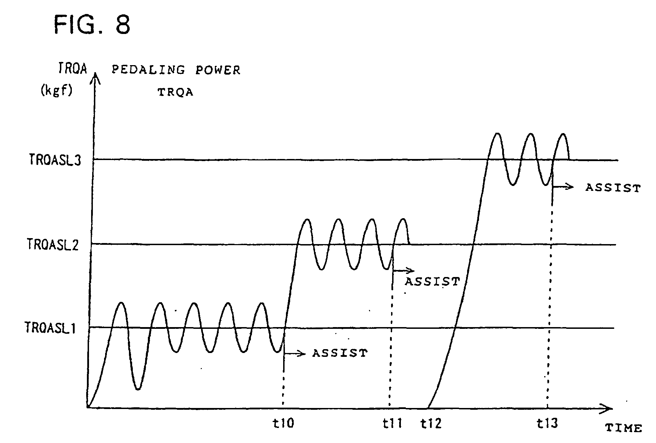

The reference value TRQASL can be set at a plurality of levels, and counter values CNTASL each corresponding to one of the levels and different from those of the other levels can be set. FIG. 8 is a diagram of assistance in explaining conditions for starting assist at each of the reference values when the plurality of reference values TRQASL are set, the diagram showing a pedaling power history. In the figure, a reference value TRQASL1 corresponds to pedaling power at the time of gradual acceleration during cruising on a flat road, and is set at 20 kgf, for example. A reference value TRQASL2 corresponds to pedaling power at the time of entering a gentle upward slope, and is set at 30 kgf, for example. A reference value TRQASL3 corresponds to pedaling power at the time of starting to move, going up a steep slope, or sharp acceleration during cruising, and is set at 35 kgf, for example. A counter value CNTASL1 corresponding to the reference value TRQASL1 is set at "5." A counter value CNTASL2 corresponding to the reference value TRQASL2 is set at "3." A counter value CNTASL3 corresponding to the reference value TRQASL3 is set at "2." These settings may of course be made arbitrarily according to characteristics of the vehicle and the user.

With such settings, referring to FIG. 8, at a time t10 after gradual acceleration during cruising on a flat road, the counter value CNTASL1 is "0" and the pedaling power TRQA exceeds the reference value TRQASL1, whereby assist is started with a pedaling power ratio (assist ratio) corresponding to the reference value TRQASL1. At a time t11 after entering a gentle upward slope, the counter value CNTASL2 is "0" and the pedaling power TRQA exceeds the reference value TRQASL2, whereby the assist is changed to assist with an assist ratio corresponding to the reference value TRQASL2. At a time t13 a short time after a traveling start time t12, the counter value CNTASL3 is "0" and the pedaling power TRQA exceeds the reference value TRQASL3, whereby assist is started with an assist ratio corresponding to the reference value TRQASL3.

The counter values CNTASL1 to CNTASL3 are initialized when assist is stopped and when a CPU is reset.

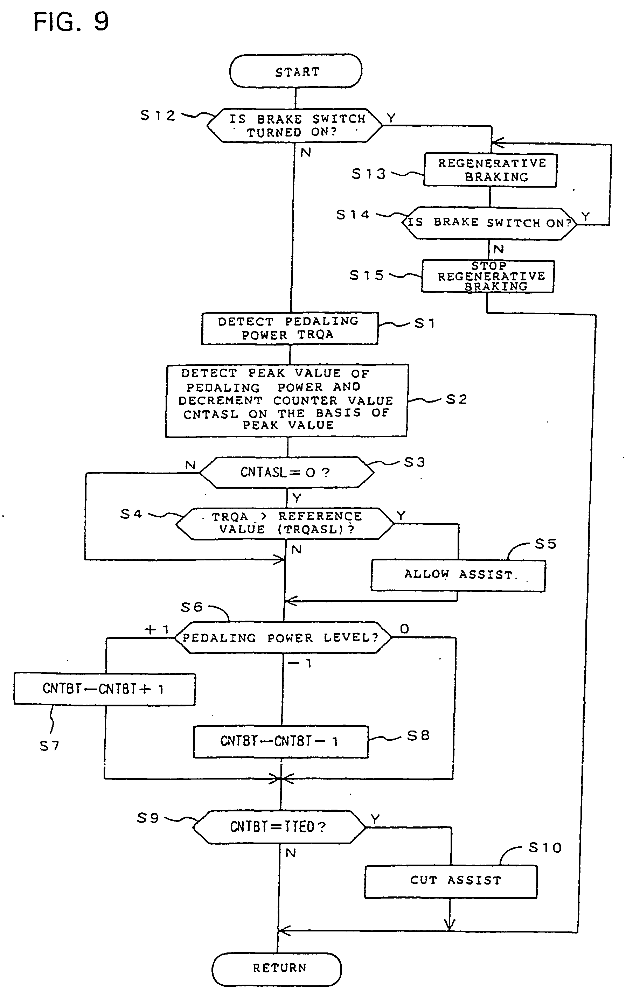

FIG. 9 is a flowchart illustrating main parts of processing in the eco mode including the assist and the assist cut described with reference to FIG. 6 and FIG. 7. First, at a step S12, whether the brake switch is turned on is determined, and when the determination is negative, the processing proceeds to a step S1, and when the determination is positive, the processing proceeds to a step S13. At the step S13, regenerative braking is continued while the brake switch is on (determination is positive at a step S14). When the brake switch is turned off, the processing proceeds to a step S15 to stop the regenerative braking.

Next, at the step S1, the pedaling power TRQA is detected. At a step S2, the peak value of the pedaling power TRQA is detected. When the peak value of the pedaling power TRQA exceeds the reference value TRQASL, the counter value CNTASL is decremented, and when the peak value of the pedaling power TRQA does not exceed the reference value TRQASL, the counter value CNTASL is reset. At a step S3, whether the pedaling power is at the assist level corresponding to the reference value TRQASL is determined on the basis of whether the counter value CNTASL is "0." At a step S4, whether the pedaling power TRQA (current value) exceeds the reference value TRQASL is determined.

When the determination at the step S4 is positive, that is, when the pedaling power is at the predetermined level and the current pedaling power TRQA has exceeded the reference value TRQASL, the processing proceeds to a step S5 to allow assist. In this assist, assist power is calculated on the basis of an assist ratio determined from the reference value TRQASL of the pedaling power and the vehicle speed, and then an output of the assist motor M is controlled so as to provide the assist power.

At a step S6, whether the pedaling power is at the assist cut level is determined on the basis of relation in magnitude between the pedaling power TRQA and the pedaling power upper limit value TRQUP and the pedaling power lower limit value TRQBT. At a step S7, according to a result of the determination at the step S6, the counter value CNTBT is incremented when the level of the pedaling power is +1 (step S7). The counter value CNTBT is decremented when the level of the pedaling power is -1 (step S8). When the level of the pedaling power is 0, the processing proceeds to a step S9 without changing the counter value CNTBT. Reversely, the counter value CNTBT may be decremented when the pedaling power is at the assist cut level, and the counter value CNTBT may be incremented otherwise.

At the step S9, whether the pedaling power TRQA remains at a predetermined low level, that is, the assist cut level is determined on the basis of whether the counter value CNTBT has reached the reference value TTED. In the case where the counter value CNTBT is decremented when the pedaling power TRQA is at the assist cut level, the initial value of the counter value CNTBT is set to be the reference value TTED, and whether the pedaling power TRQA remains at the assist cut level is determined on the basis of whether the counter value CNTBT has reached zero. When it is determined that the pedaling power remains at the assist cut level, the processing proceeds to a step S10 to cut the assist.

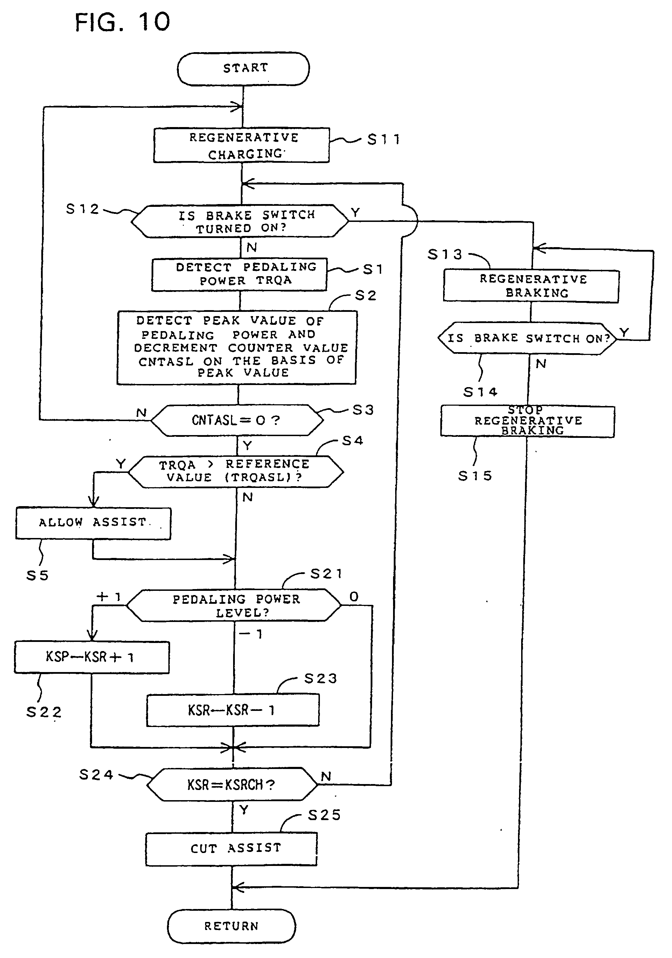

FIG. 10 is a flowchart illustrating main parts of processing in the super eco mode including the assist and the regenerative charging described with reference to FIG. 6 and FIG. 7. Since control to allow assist is the same as in the eco mode (FIG. 9), the processing for the control to allow assist is identified by the same reference numerals, that is, the steps S1 to S5, and its description will be omitted.

At a step S11, regenerative charging is performed. At a step S12, whether the brake switch is turned on is determined. The brake switch is turned on when the brake lever 27B is operated. Incidentally, a braking amount detecting potentiometer may be provided in place of the brake switch to use a voltage value of the braking amount detecting potentiometer. When the determination at the step S12 is positive, the processing proceeds to a step S13, whereas when the determination at the step S12 is negative, the processing proceeds to the step S1. At the step S13, regenerative braking is performed. At the step S14, whether the brake switch is turned off is determined. When the brake switch is not turned off, the regenerative braking is continued, whereas when the brake switch is turned off, the processing proceeds to a step S15 to stop the regenerative braking. During the regenerative braking, the higher the vehicle speed, the larger the amount of regenerative charging. When the regenerative braking is stopped, the processing returns to the step S11. Incidentally, the steps S12 to S15 represent conventionally performed regenerative braking.

When the determination at the step S12 is negative, the processing for allowing assist is performed at the steps S1 to S5.

The assist allowing processing is followed by regenerative charging start level processing at a step S21. Specifically, as shown in FIG. 6, whether the pedaling power is at a regenerative charging start level is determined on the basis of relation in magnitude between the pedaling power TRQA and the pedaling power upper limit value TRQUP and the pedaling power lower limit value TRQBT. At a step S22, according to a result of the determination at the step S21, the counter value KSR is incremented when the level of the pedaling power is +1 (step S22). The counter value KSR is decremented when the level of the pedaling power is -1 (step S23). When the level of the pedaling power is 0, the processing proceeds to a step S24 without changing the counter value KSR. Reversely, the counter value KSR may be decremented when the pedaling power is at the regenerative charging start level, and the counter value KSR may be incremented otherwise.

At the step S24, whether the pedaling power TRQA remains at a predetermined low level, that is, the regenerative charging start level is determined on the basis of whether the counter value KSR has reached a reference value KSRCH (= TTED). In the case where the counter value KSR is decremented when the pedaling power is at the regenerative charging start level, the initial value of the counter value KSR is set to be the reference value KSRCH, and whether the pedaling power remains at the regenerative charging start level is determined on the basis of whether the counter value KSR has reached zero. When it is determined that the pedaling power remains at the regenerative charging start level (the determination at the step S24 is positive), assist is cut at a step S25. Then the processing returns and proceeds to the step S11 to perform regenerative charging. When the determination at the step S24 is negative, the pedaling power is not at the regenerative charging start level, and thus the processing returns to the step S12 to repeat the processing steps described above. Incidentally, when the pedaling power lower limit value TRQBT in FIG. 6 is set lower, for example set lower than the range of 13 to 15 kgf, it is possible to perform regenerative charging only at the time of descending a slope.

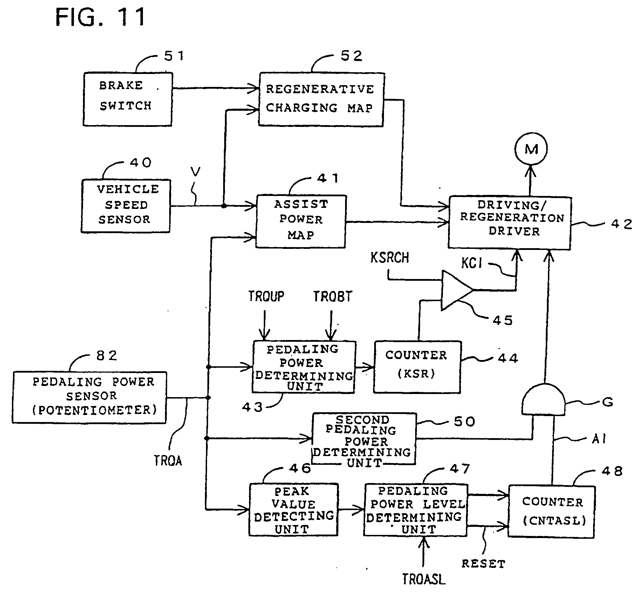

FIG. 11 is a block diagram of functions of main parts of the controller 100 for processing in the super eco mode. Incidentally, the functions can be realized by a microcomputer including a CPU. In the figure, output data (vehicle speed V) of a vehicle speed sensor 40 is captured by an assist power map 41 and a regenerative charging map 52 in predetermined interruption timing. Output data (pedaling power TRQA) of the potentiometer 82 serving as a pedaling power sensor is captured by the assist power map 41. An on/off output of the brake switch is captured by the regenerative charging map 52. Assist power data is set in the assist power map 41 to provide a predetermined assist ratio on the basis of the vehicle speed V and the pedaling power TRQA. Regeneration data is set in the regenerative charging map 52 to perform predetermined regenerative charging based on the vehicle speed when the brake switch is turned on. In response to input of the vehicle speed V and the pedaling power TRQA, the assist power map 41 outputs assist power data. The assist power map is for example set so as to decrease the assist power, that is, lower the assist ratio even at the same pedaling power TRQA as the vehicle speed V is increased. The regenerative charging map 52 outputs regeneration data (regeneration control signal) corresponding to the vehicle speed when the brake switch 51 is turned on. The regenerative charging map is for example set such that the amount of regenerative charging is increased as the vehicle speed is increased.

The assist power data and the regeneration data are inputted to a driving/regeneration driver 42. The driving/regeneration driver 42 controls an output of the assist motor M or the actuator 7 according to the assist power data or the regeneration data. Incidentally, the vehicle speed sensor 40 can be formed for example by means that magnetically detects regular projections and depressions provided on the periphery of the supporting plate 102 in the electric assist unit 1 and outputs the vehicle speed V on the basis of the number of projections and depressions detected or detection intervals of projections and depressions.

A pedaling power determining unit 43 determines the magnitude of the current pedaling power TRQA with respect to pedaling power reference values (for example the pedaling power upper limit value TRQUP and the pedaling power lower limit value TRQBT), and increments or decrements the counter value KSR of a low level counter 44 according to a result of the determination. A comparator unit 45 compares the counter value KSR of the low level counter 44 with the reference value KSRCH, and outputs a regeneration instruction KCI to the driving/regeneration driver 42 when the counter value KSR has reached the reference value KSRCH. The pedaling power determining unit 43, the low level counter 44, and the comparator unit 45 form regeneration level detecting means.

A peak value detecting unit 46 is supplied with the pedaling power TRQA from the pedaling power sensor 82, and detects a peak value of the periodically varying pedaling power TRQA. The peak value is inputted to a pedaling power level determining unit 47. The pedaling power level determining unit 47 updates the counter value CNTASL of an assist counter 48 when the pedaling power level determining unit 47 determines that the peak value exceeds the predetermined pedaling power level TRQASL. The assist counter 48 outputs an assist allowing instruction AI when the counter value CNTASL has reached a predetermined value. The assist allowing instruction is inputted to the driving/regeneration driver 42 via a gate G. A second pedaling power determining unit 50 outputs a detection signal when the current pedaling power TRQA exceeds the pedaling power level TRQASL. The gate G is opened when the detection signal of the second pedaling power determining unit 50 is supplied, whereby the assist allowing instruction is inputted to the driving/regeneration driver 42. The peak value detecting unit 46, the pedaling power level determining unit 47, and the assist counter 48 form varying pedaling power level detecting means.

According to the assist allowing instruction AI or the regeneration instruction KCI, the driving/regeneration driver 42 energizes the assist motor M to provide assist or the actuator 7 to perform regenerative charging. Specifically, a conduction angle of a FET forming the driver circuit of the assist motor M or the actuator 7 is determined according to the assist power data or the regeneration data to thereby control the magnitude of the assist power or the amount of regeneration. The pedaling power level determining unit 47 outputs a reset signal to reset the counter value of the assist counter 48 to an initial value when the peak value does not exceed the pedaling power level TRQASL.

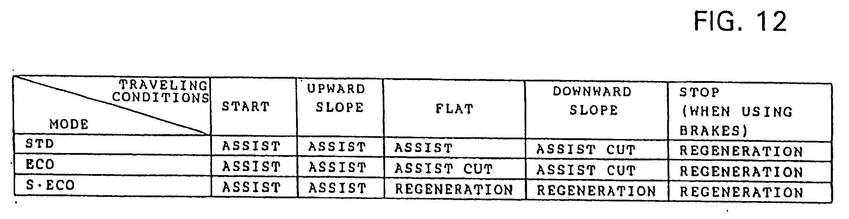

FIG. 12 is a diagram providing a rough summary of control of the assist motor according to traveling conditions in each of the STD, ECO, and S-ECO modes. Although the figure does not represent the control of the assist motor accurately, the figure is provided because the figure may help roughly understand differences between the STD, ECO, and S-ECO modes. It is clear from the figure that the S-ECO mode can increase the frequency of regenerative charging as compared with the STD and ECO modes.

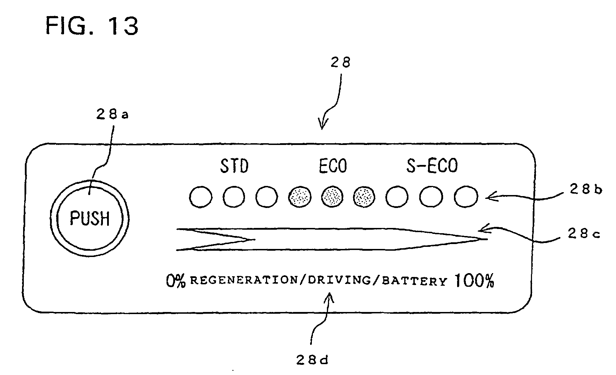

FIG. 13 is a plan view of the indicator 28 according to one embodiment of the present invention. The indicator 28 displays a charge level of the battery, an assist condition, a regenerative charge condition and the like. The indicator 28 includes: a push button 28a; mode display lamps 28b that blink when the STD (standard mode), ECO (eco mode), and S-ECO (super eco mode) are selected, the mode display lamps 28b being formed by three lamps for each of the modes; a bar graph display unit 28c for displaying 0 to 100%; and a type display unit 28d for indicating that the type of quantity shown by the bar graph represents either one of "regeneration," "driving," and "battery." Incidentally, three lamps of the mode display lamps may be substituted for the display of the bar graph display unit. The mode display lamps 28b can be formed by a light-emitting diode, for example, and the bar graph display unit 28c and the type display unit 28d can be formed by a liquid crystal.

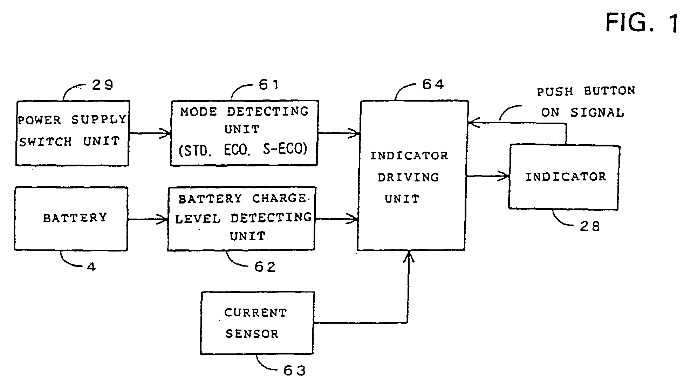

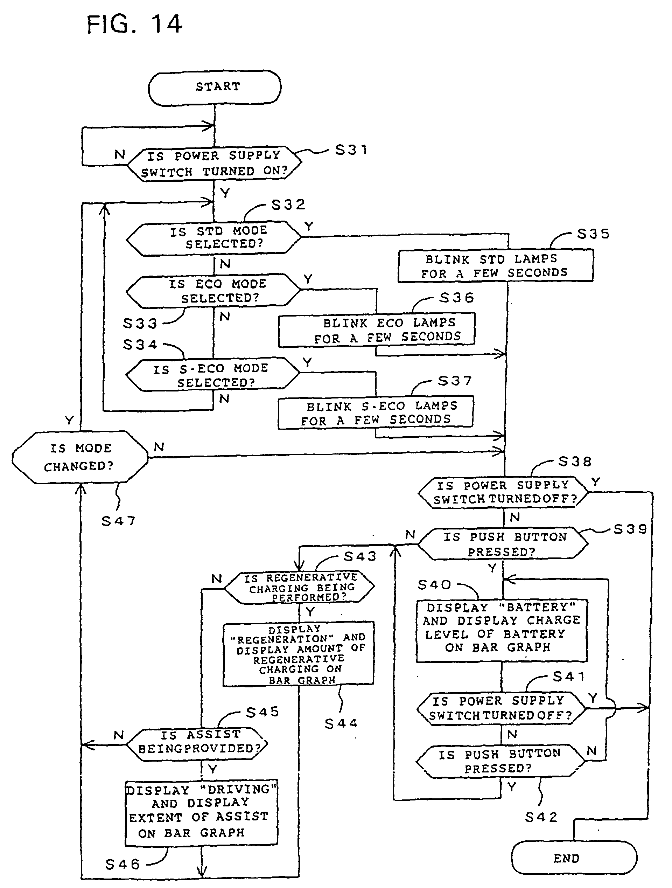

FIG. 14 is a flowchart of operation of the indicator 28 and a driving unit 64 (see FIG. 1) of the indicator 28. When it is determined at a step S31 that the power supply switch unit 29 is turned on, determination at steps S32 to S34 is made. When it is determined that the STD mode is selected (the determination at the step S32 is positive), the processing proceeds to a step S35, where three lamps of the mode display lamps 28b allocated for the STD blink for a few seconds. Similarly, when it is determined that the ECO mode is selected (the determination at the step S33 is positive), the processing proceeds to a step S36, where ECO lamps blink for a few seconds. When it is determined that the S-ECO mode is selected (the determination at the step S34 is positive), the processing proceeds to a step S37, where S-ECO lamps blink for a few seconds. Thus, the user can confirm which mode is selected. Incidentally, since the lamps blink only for a few seconds, battery consumption can be reduced.

Then, the processing proceeds to a step S38 to determine whether the power supply switch unit 29 is turned off. When the determination is negative, the processing proceeds to a step S39 to determine whether the push button 28a is pressed. When the determination is positive, the processing proceeds to a step S40 to display the "battery" of the type display unit 28d and display the charge level of the battery on the bar graph display unit 28c. At a step S41, whether the power supply switch unit 29 is turned off is determined. At a next step S42, whether the push button 28a is pressed is determined. While the determinations at the steps S41 and S42 are both negative, the charge level of the battery is displayed on the bar graph display unit 28c. When the determination at the step S42 is positive, on the other hand, the processing proceeds to steps from S43 on down. Thus, the charge level of the battery is displayed for an odd-numbered time that the push button 28a is pressed, while the display of the charge level of the battery is turned off for an even-numbered time that the push button 28a is pressed. Incidentally, when the determination at the step S42 is changed to determination of "whether a predetermined time has passed," the display of the charge level of the battery will be automatically turned off in the predetermined time.

At a step S43, whether regenerative charging is being performed is determined. When the regenerative charging is being performed, the processing proceeds to a step S44 to display the "regeneration" and display the amount of regenerative charging on the bar graph display unit 28c. When the determination at the step S43 is negative, the processing proceeds to a step S45 to determine whether assist is being provided. When the determination is positive, the processing proceeds to a step S46 to display the "driving" and display the extent of the assist on the bar graph display unit 28c. Then, the processing proceeds to a step S47 to determine whether an operation for mode change is performed. When the operation for mode change is performed, the processing proceeds to the steps S32 to S34 to determine the selected mode. When the operation for mode change is not performed, on the other hand, the processing proceeds to the step S38 to repeat operations at the steps S38 to S46. When it is determined at the steps S38 and S41 that the power supply switch unit 29 is turned off, the indicator 28 is turned off.

Hence, a glance at display on the indicator 28 shows the user which of the STD, ECO, and S-ECO modes is selected, the extent of the assist, or the amount of regenerative charging during traveling, thus allowing the user to do the cycling with pleasure. Regeneration display in particular allows the user to be aware of the amount of exercise of the user himself/herself and thus give renewed recognition as a fitness tool to the motor-assisted bicycle.

FIG. 1 is a block diagram showing a circuit configuration around the indicator 28. A mode selected at the power supply switch unit 29 is detected by a mode detecting unit 61, and a mode signal is supplied to an indicator driving unit 64. The charge level of the battery 4 is detected by a battery charge level detecting unit 62, and then supplied to the indicator driving unit 64. A current sensor 63 detects current supplied to and from the battery, and outputs a result to the indicator driving unit 64. The indicator driving unit 64 performs operations described with reference to the flowchart of FIG. 14. When the changing of the mode is detected by the mode detecting unit 61, the indicator driving unit 64 blinks the mode display lamps 28b of the indicator 28 for a few seconds. When the push button 28a of the indicator 28 is pressed, the indicator driving unit 64 displays the "battery" and displays the charge level of the battery on the bar graph display unit 28c. As for the "regeneration" and "driving," the indicator driving unit 64 displays the amount of regeneration and driving on the basis of the current obtained by the current sensor 63 on the bar graph display unit 28c.

As is clear from the above description, according to the invention as set forth in claim 1, the user can be made aware that the amount of exercise of the user contributes to regenerative charging during traveling, thus giving renewed recognition as a fitness tool to the motor-assisted bicycle. The user is aware that the amount of exercise of the user is stored in the battery and is not wasted, and thus the user feels invigorated.

According to the invention as set forth in claims 2 and 3, the user can grasp conditions of the assist motor at a glance, and thus can travel while recognizing excellent functions of the motor-assisted bicycle according to the present invention.

According to the invention as set forth in claims 4 and 5, the user can grasp the charge level of the battery anytime by operating the push button, and thus can prevent battery exhaustion.

In addition, according to the invention as set forth in claims 1 to 5, conditions of the assist motor can be visually displayed to the operator during traveling, and thus it is possible to increase the attraction of the motor-assisted bicycle as a product.

In summary it is an object to provide an indicator that displays conditions of assist, regenerative charging and the like and allows an operator to visually check the conditions. To achieve this, an indicator 28 attached to a part of a handlebar of a motor-assisted bicycle includes: a push button 28a; mode display lamps 28b for displaying conditions of an assist motor, that is, a standard (STD) mode, an ECO mode, and an S-ECO mode; a bar graph 28c; and a type display unit 28d for displaying either one of "regeneration," "driving," and "battery." When the assist motor is switched to the ECO mode, for example, three lamps associated with the ECO mode blink for a few seconds to notify the change. At a time of regeneration (or driving) during traveling, the regeneration (driving) on the type display unit 28d is displayed brightly and an amount of regenerative charging (assist) is displayed on the bar graph 28c. When the push button 28a is pressed, the battery on the type display unit 28d is displayed brightly and a battery charge level is displayed on the bar graph 28c.

## Claims

1. An indicator (28) of a motor-assisted bicycle for displaying conditions of an assist motor of the battery-equipped motor-assisted bicycle that adds assist power to a human power driving system according to pedaling power applied to a pedal (12), said indicator (28) comprising:
a first display unit (28c) displaying an amount of regenerative charging of the battery (4),
**characterized in that** the indicator (28) further comprises a second display unit (28b) displaying a control mode condition of said assist motor.

2. An indicator (28) of a motor-assisted bicycle as claimed in claim 1, , wherein
said second display unit (28b) displays each of a standard (STD) mode in which assist is provided at other than a time of descending a slope and a regeneration mode is provided at a time of operation of brakes, an eco mode with a lower frequency of assist than that of said standard mode, and
a super eco mode with a lower frequency of assist and a higher frequency of regeneration than those of said standard mode.

3. An indicator (28) of a motor-assisted bicycle as claimed in claim 1, further comprising:
a push button (28a); and
a third display unit (28c) for displaying a battery charge level when the push button is operated.

4. An indicator (28) of a motor-assisted bicycle as claimed in claim 3, wherein
one display unit (28c) is used as said first display unit (28c) and said third display unit (28c), and
both said first display unit (28c) and said third display unit (28c) are switched to each other for display by operation of the push button (28a).

## Patentansprüche

1. Anzeigevorrichtung (28) eines motorunterstützten Fahrrads zur Anzeige von Zuständen eines Hilfsmotors des mit einer Batterie versehenen motorunterstützten Fahrrads, welcher einem Muskelkraftantriebssystem gemäß der auf ein Pedal (12) ausgeübten Tretkraft eine Hilfskraft hinzufügt, wobei die Anzeigevorrichtung (28) umfasst:
eine erste Anzeigeeinheit (28c), welche einen Wert einer regenerativen Ladung der Batterie (4) anzeigt,
**dadurch gekennzeichnet, dass** die Anzeigevorrichtung (28) ferner eine zweite Anzeigeeinheit (28b) umfasst, welche einen Steuer/Regeimoduszustand des Hilfsmotors anzeigt.

2. Anzeigevorrichtung (28) eines motorunterstützten Fahrrads nach Anspruch 1, wobei
die zweite Anzeigeeinheit (28b) jeden von einem Standard (STD)-Modus, bei dem außer während einer Bergabfahrt eine Unterstützung vorgesehen ist und während einer Bremsenbetätigung ein Regenerationsmodus vorgesehen ist,
einem Ökomodus mit einer niedrigeren Unterstützungsfrequenz als der des Standardmodus und
einem Super-Ökomodus mit einer niedrigeren Unterstützungsfrequenz und einer höheren Regenerationsfrequenz als denen des Standardmodus, anzeigt.

3. Anzeigevorrichtung (28) eines motorunterstützten Fahrrads nach Anspruch 1, ferner umfassend:
einen Druckknopf (28a); und
eine dritte Anzeigeeinheit (28c) zur Anzeige eines Batterieladungsniveaus, wenn der Druckknopf betätigt wird.

4. Anzeigevorrichtung (28) eines motorunterstützten Fahrrads nach Anspruch 3, wobei
eine Anzeigeeinheit (28c) als die erste Anzeigeeinheit (28c) und die dritte Anzeigeeinheit (28c) verwendet wird, und
sowohl die erste Anzeigeeinheit (28c) als auch die dritte Anzeigeeinheit (28c) durch eine Betätigung des Druckknopfs (28a) zueinander zur Anzeige umgeschaltet werden.

## Revendications

1. Indicateur de charge (28) pour bicyclette à assistance motorisée destiné à afficher des conditions d'un moteur d'assistance de la bicyclette à assistance motorisée équipé d'une batterie qui fournit en complément une puissance d'assistance à un système d'entraînement par puissance musculaire humaine en fonction d'une puissance de pédalage qui est appliquée sur une pédale (12), ledit indicateur de charge (28) comprenant : un premier afficheur (28c) qui affiche une valeur de charge de régénération de la batterie (4),
**caractérisé en ce que** ledit indicateur de charge (28) comprend en outre un second afficheur (28b) qui affiche une condition de mode de commande dudit moteur d'assistance.

2. Indicateur de charge (28) pour bicyclette à assistance motorisée selon la revendication 1, dans lequel ledit second afficheur (28b) affiche chacun :
d'un mode "Standard" (STD) dans lequel l'assistance est fournie à un autre moment qu'à un moment de descente d'une pente et un mode de régénération est fourni à un moment d'action sur les freins ;
d'un mode "Eco" dont la fréquence d'assistance est plus faible que celle dudit mode standard ; et
d'un mode "Super Eco" dont la fréquence d'assistance est plus faible et la fréquence de régénération plus élevée que celles du mode standard.

3. Indicateur de charge (28) pour bicyclette à assistance motorisée selon la revendication 1, comprenant en outre :
un bouton poussoir (28a) ; et
un troisième afficheur (28c) destiné à afficher un niveau de charge de batterie lorsque le bouton poussoir est actionné.

4. Indicateur de charge (28) pour bicyclette à assistance motorisée selon la revendication 3, dans lequel :
un afficheur (28c) est utilisé en tant que dit premier afficheur (28c) et en tant que dit troisième afficheur (28c) ; et
lesdits deux premier afficheur (28c) et troisième afficheur (28c) sont commutés l'un avec l'autre à des fins d'affichage au moyen d'une action sur le bouton poussoir (28a).
